# EUROPEAN PATENT SPECIFICATION

(11) **EP 3 813 496 B1**
(45) Date of publication and mention of the grant of the patent: **20.08.2025**
(21) Application number: 19911964.5
(22) Date of filing: 13.12.2019
(51) Int. Cl.: H05K 1/02, H05K 3/46

(54) **STRETCHABLE WIRING BOARD**
DEHNBARE LEITERPLATTE
CARTE DE CÂBLAGE EXTENSIBLE

(30) Priority: 21.01.2019 JP 2019007740
(43) Date of publication of application: 28.04.2021
(73) Proprietor: Murata Manufacturing Co., Ltd., Nagaokakyo-shi, Kyoto 617-8555 (JP)
(72) Inventor: TOMODA, Takahito, Nagaokakyo-shi, Kyoto 617-8555 (JP)
(74) Representative: von Tietzen und Hennig, Nikolaus
(86) International application number: PCT/JP2019/048992
(87) International publication number: WO 2020/153044

(56) References cited:
- WO-A1-2018/060554
- JP-A- 2015 119 071
- JP-A- 2017 183 328
- JP-A- 2018 164 015
- JP-A- 2019 140 292
- US-A1- 2010 143 848
- US-A1- 2014 022 746
- US-A1- 2015 351 221

## Description

### TECHNICAL FIELD

The present invention relates to a stretchable wiring board.

### BACKGROUND ART

In recent years, it has been practiced to manage a state of a living body (for example, a human body) by acquiring and analyzing biological information using a wiring board.

When a plurality of wiring lines are arranged on a wiring board, the wiring lines may be crossed with each other. For example, Patent Document 1 discloses a method of forming a wiring layer having an overhead intersection portion on a substrate.

### PRIOR ART DOCUMENT

### PATENT DOCUMENT

Patent Document 1: Japanese Patent Application Laid-Open No. H09-51000

### SUMMARY OF THE INVENTION

### Problem to be solved by the invention

The wiring board attached to the living body is required to be a stretchable wiring board that can follow the movement of the living body. Further, even in the above stretchable wiring board, a plurality of wiring lines may be arranged so as to overlap (for example, intersect) with each other, but it is necessary to prevent a short circuit between the wiring lines. Therefore, in order to prevent the short circuit between the wiring lines, an insulating layer may be interposed between the plurality of overlapping wiring lines. Therefore, the portion where the wiring lines and the insulating layer are stacked may greatly protrude. For example, when the plurality of wiring lines intersect with each other three-dimensionally with the insulating layer interposed therebetween, the overhead intersection portion may greatly protrude.

Patent Document 1 does not disclose that the substrate has stretchability. Even if the substrate has stretchability, there is a problem that, when the substrate stretches, stress tends to concentrate on the overhead intersection portion of the wiring layer that greatly protrudes, and as a result, the wiring layer is easily broken.

A wiring board comprising a stretchable structure is known from WO 2018/060554 A1. The board comprises a first conductive path passing underneath a second conductive path in the interface region. An insulating layer is provided in interface region to isolate the conductive paths from one another. Further wiring boards are disclosed in any of US 2010/143848 A1, US 2015/351221 A1, US 2014/022746 A1 and JP 2019 140292 A.

The present invention has been made to solve the above problem, and it is an object of the present invention to provide a stretchable wiring board that can suppress breakage of a stretchable wiring line during stretching, while preventing the short circuit between two stretchable wiring lines when the two stretchable wiring lines are arranged so as to overlap with each other.

### Means for solving the problem

A stretchable wiring board according to the present invention comprises the features according to claim 1. Preferred aspect of the invention are subject-matter of the dependent claims.

### Advantageous effect of the invention

According to the present invention, it is possible to provide the stretchable wiring board that can suppress breakage of the stretchable wiring line during stretching, while preventing a short circuit between two stretchable wiring lines when the two stretchable wiring lines are arranged so as to overlap with each other.

### BRIEF EXPLANATION OF DRAWINGS

FIG. 1 is a schematic plan view showing an example of a stretchable wiring board of the present invention.
FIG. 2 is a schematic sectional view showing a portion corresponding to a line segment A-A' in FIG. 1.
FIG. 3 is a sectional photograph showing an example of the stretchable wiring board of the present invention.
FIG. 4 is schematic plan view showing an example of a mounting board in which an electronic component is mounted on the stretchable wiring board of the present invention.

### MODE FOR CARRYING OUT THE INVENTION

Hereinafter, a stretchable wiring board of the present invention is described. The present invention is not limited to the following configuration.

In the present description, "thickness" means a length in a direction perpendicular to the surface of the stretchable substrate in sectional view. Further, the "thickness" and the "length" are shown as those in a state of the stretchable wiring board not being stretched.

### [Stretchable wiring board]

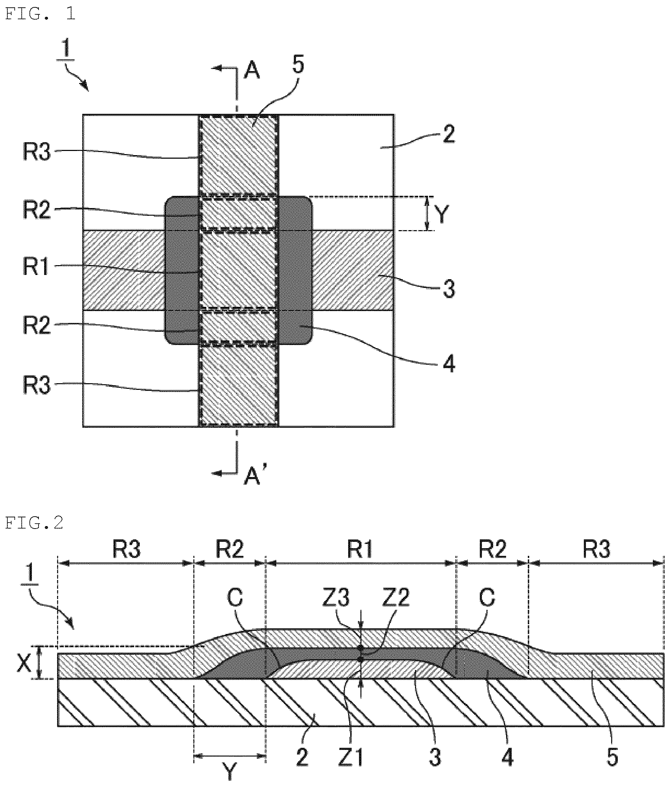

FIG. 1 is a schematic plan view showing an example of the stretchable wiring board of the present invention. FIG. 2 is a schematic sectional view showing a portion corresponding to a line segment A-A' in FIG. 1. As shown in FIGS. 1 and 2, a stretchable wiring board 1 has a stretchable substrate 2, a first stretchable wiring line 3, an insulating layer 4, and a second stretchable wiring line 5.

The first stretchable wiring line 3 is arranged on the surface of the stretchable substrate 2.

The insulating layer 4 is arranged so as to overlap with a part of the first stretchable wiring line 3 in plan view.

The second stretchable wiring line 5 is arranged such that a part thereof overlaps with the first stretchable wiring line 3, with the insulating layer 4 interposed therebetween in plan view.

In the stretchable wiring board 1, there are a first region R1, a second region R2 adjacent to the first region R1, and a third region R3 adjacent to the second region R2 along the extending direction of the second stretchable wiring line 5 (the direction of the line segment A-A' in FIG. 1). That is, the second stretchable wiring line 5 extends over the first region R1, the second region R2, and the third region R3.

In the first region R1, the first stretchable wiring line 3, the insulating layer 4, and the second stretchable wiring line 5 are arranged so as to sequentially overlap on the surface of the stretchable substrate 2.

In the second region R2, the insulating layer 4 and the second stretchable wiring line 5 are arranged so as to sequentially overlap on the surface of the stretchable substrate 2. The first stretchable wiring line 3 is not arranged in the second region R2.

In the third region R3, the second stretchable wiring line 5 is arranged on the surface of the stretchable substrate 2. The first stretchable wiring line 3 and the insulating layer 4 are not arranged in the third region R3.

The insulating layer 4 extends over the first region R1 and the second region R2**.**

As a result, the first stretchable wiring line 3 and the second stretchable wiring line 5 are electrically insulated, and a short circuit between the two stretchable wiring lines is prevented.

### <Stretchable substrate>

Examples of the constituent material of the stretchable substrate 2 include a resin material such as thermoplastic polyurethane.

When the stretchable wiring board 1 is, for example, attached to a living body, the thickness of the stretchable substrate 2 is preferably 100 µm or less, more preferably 1 µm or less, from the viewpoint of not inhibiting the stretching of the surface of the living body. The thickness of the stretchable substrate 2 is preferably 0.1 µm or more.

### <First stretchable wiring line and second stretchable wiring line>

As the constituent material of the first stretchable wiring line 3 and the second stretchable wiring line 5, a mixture of conductive particles and resin is preferable. Examples of the above mixture include a mixture of metal powder such as silver, copper and nickel as conductive particles and an elastomer resin such as a silicone resin. The average particle size of the conductive particles is preferably 0.01 µm or more and 10 µm or less. The shape of the conductive particles is preferably spherical. The constituent material of the first stretchable wiring line 3 and the second stretchable wiring line 5 may be the same or different from each other.

The thickness of the first stretchable wiring line 3 and the second stretchable wiring line 5 is preferably 100 µm or less, more preferably 50 µm or less, respectively. The thickness of the first stretchable wiring line 3 and the second stretchable wiring line 5 is preferably 1 µm or more, respectively. The thicknesses of the first stretchable wiring line 3 and the second stretchable wiring line 5 may be the same or different from each other.

### <Insulating layer>

As the constituent material of the insulating layer 4, resin material or a mixture of resin material and inorganic material is preferable. Examples of the resin material include an elastomer resin such as urethane-based, styrene-based, olefin-based, silicone-based, fluorine-based, nitrile rubber, latex rubber, vinyl chloride, ester-based, and amide-based resins, epoxy, phenol, acrylic, polyester, imide-based, rosin, cellulose, polyethylene terephthalate-based, polyethylene naphthalate-based, and polycarbonate-based resins.

The thickness of the insulating layer 4 is preferably 100 µm or less, more preferably 50 µm or less. The thickness of the insulating layer 4 is preferably 5 µm or more.

The thickness of the first stretchable wiring line 3 is defined as Z1, the thickness of the insulating layer 4 as Z2, and the thickness of the second stretchable wiring line 5 as Z3 at a position in the first region R1 where the total thickness of the first stretchable wiring line 3, the insulating layer 4, and the second stretchable wiring line 5 becomes maximum, and the thickness of the second stretchable wiring line 5 at a boundary between the second region R2 and the third region R3 is defined as X. At this time, the stretchable wiring board 1 satisfies the relationship that X is larger than the larger of Z1 + Z2 and Z2 + Z3, and smaller than Z1 + Z2 + Z3. If the thickness X of the second stretchable wiring line 5 is not constant depending on the observed section, both the minimum value and the maximum value of the thickness may satisfy the above relationship.

From the viewpoint of suppressing the protrusion of the first region R1, it is preferable that X = Z1 + Z2 + Z3, but in this case, the stretchability of the second stretchable wiring line 5 is hindered because X becomes excessive. On the other hand, by making X larger than the larger of Z1 + Z2 and Z2 + Z3 and smaller than Z1 + Z2 + Z3 as in the above relationship, X does not become excessive, and also, the difference between Z1 + Z2 + Z3 and X (the size of the protrusion in the first region R1) is smaller than the smaller of Z1 and Z3. Therefore, the protrusion of the first region R1 is minimized, and the surface of the stretchable wiring board 1 becomes substantially flat over the first region R1, the second region R2, and the third region R3. Therefore, even if the stretchable wiring board 1 is stretched, the stress generated in the first region R1 is suppressed, and as a result, the first stretchable wiring line 3 and the second stretchable wiring line 5 are not easily broken. The above effect can be obtained even when the stretchable wiring board 1 is stretched and bent.

If X is smaller than the larger of Z1 + Z2 and Z2 + Z3, the first region R1 will protrude significantly. Therefore, when the stretchable wiring board 1 is stretched, the stress tends to concentrate on the first region R1, and as a result, the first stretchable wiring line 3 and the second stretchable wiring line 5 become easily broken.

If X is larger than Z1 + Z2 + Z3, the vicinity of the boundary between the second region R2 and the third region R3 greatly protrudes. Therefore, when the stretchable wiring board 1 is stretched, stress tends to concentrate in the vicinity of the boundary between the second region R2 and the third region R3, and as a result, the second stretchable wiring line 5 becomes easily broken.

The stretchable wiring board 1 is manufactured, for example, by forming the first stretchable wiring line 3, the insulating layer 4, and the second stretchable wiring line 5 in this order on the surface of the stretchable substrate 2. Note that in order to satisfy the relationship that X is larger than the larger of Z1 + Z2 and Z2 + Z3 and smaller than Z1 + Z2 + Z3 in the stretchable wiring board 1, for example, the following methods (A) and (B) may be adopted.
(A) In the vicinity of the boundary between the second region R2 and the third region R3, the second stretchable wiring line 5 is formed thick (may be formed over multiple times in an overlapping manner), and X is increased (close to Z1 + Z2 + Z3).
(B) In the first region R1, the surface of the second stretchable wiring line 5 is scraped to make Z1 + Z2 + Z3 smaller (closer to X).

When the stretchable wiring board 1 is stretched (or stretched and bent), the first stretchable wiring line 3 and the second stretchable wiring line 5 get close to each other particularly in the vicinity of the boundary between the first region R1 and the second region R2, and the short circuit and electric leakage between the two stretchable wiring lines may easily occur. On the other hand, from the viewpoint of widening the distance between the first stretchable wiring line 3 and the second stretchable wiring line 5 in the vicinity of the boundary between the first region R1 and the second region R2, it is preferable that the stretchable wiring board 1 have the following configuration.

### (First preferred configuration)

As shown in FIG. 2, in sectional view, corners C of the first stretchable wiring line 3 (corners on the far side from the stretchable substrate 2, in other words, the corners that are not in contact with the stretchable substrate 2) are preferably R-shaped. As a result, the corners C of the first stretchable wiring line 3 are shaped so as to recede toward the inside of the first region R1, therefore, in the vicinity of the boundary between the first region R1 and the second region R2, the distance between the first stretchable wiring line 3 and the second stretchable wiring line 5 becomes sufficiently wide. Therefore, even if the stretchable wiring board 1 is stretched (or stretched and bent), the first stretchable wiring line 3 and the second stretchable wiring line 5 do not come too close to each other, and as a result, the short circuit and electric leakage between the two stretchable wirings do not easily occur.

In the present specification, the "R shape" means a shape in which at least a part of the contour is constituted of a curved line and is generally rounded, and for example, a shape having a right-angled contour is excluded.

### (Second preferred configuration)

As shown in FIG. 1, in plan view, the minimum value of the length of the second region R2 in the extending direction of the second stretchable wiring line 5 is defined as Y. At this time, it is preferable to satisfy the relationship of Y > Z2. As a result, the insulating layer 4 becomes thicker in the vicinity of the corners C of the first stretchable wiring line 3, and therefore, the distance between the first stretchable wiring line 3 and the second stretchable wiring line 5 becomes sufficiently wide in the vicinity of the boundary of the first region R1 and the second region R2. Therefore, even if the stretchable wiring board 1 is stretched (or stretched and bent), the first stretchable wiring line 3 and the second stretchable wiring line 5 do not come too close to each other, and as a result, the short circuit and electric leakage between the two stretchable wirings do not easily occur.

In the stretchable wiring board 1, as shown in FIG. 1, in plan view, the first stretchable wiring line 3 and the second stretchable wiring line 5 may intersect, but a part of the above stretchable wiring lines may overlap without intersecting with each other. If the first stretchable wiring line 3 and the second stretchable wiring line 5 intersect with each other, the intersection angle may be a right angle or may be other than a right angle.

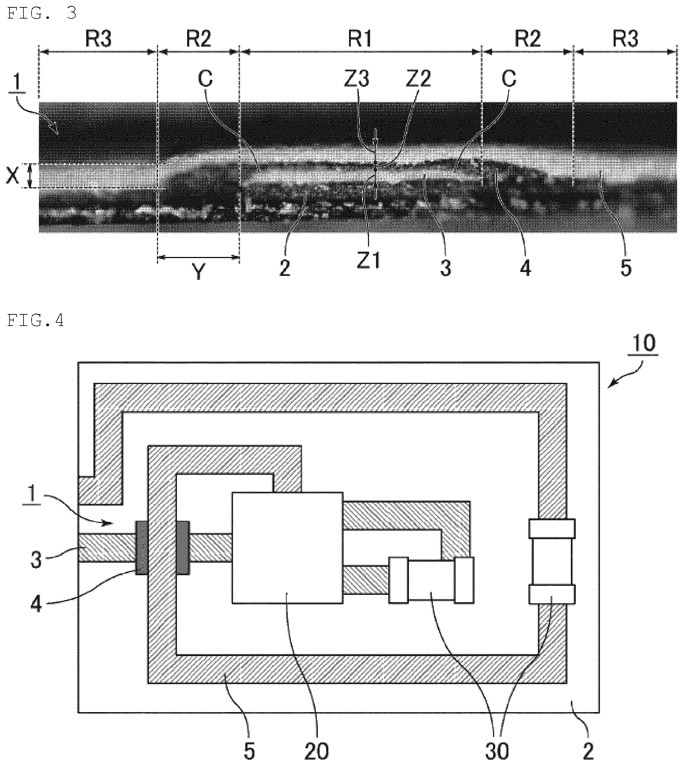

FIG. 3 is a sectional photograph showing an example of the stretchable wiring board of the present invention. As shown in FIG. 3, in the sectional photograph of the stretchable wiring board 1, the relationship of X being larger than the larger of Z1 + Z2 and Z2 + Z3 and smaller than Z1 + Z2 + Z3 is satisfied. It can also be seen that the corners C of the first stretchable wiring line 3 each has the R shape and the relationship of Y> Z2 is satisfied.

Electronic components may be mounted on the stretchable wiring board 1. FIG. 4 is a schematic plan view showing an example of a mounting board in which electronic components are mounted on the stretchable wiring board of the present invention. As shown in FIG. 4, a mounting board 10 includes the stretchable wiring board 1 and chip components 20 and 30 as electronic components mounted on the stretchable wiring board 1.

Examples of the chip components 20 and 30 include amplifiers (op amps, transistors, etc.), resistors, capacitors, inductors, and others.

The mounting board 10 (stretchable wiring board 1) can be used as a sensor by being attached to a living body (for example, a human body).

The mounting board 10 (stretchable wiring board 1) may further include an adhesive layer having biocompatibility on the surface on the side opposite to the first stretchable wiring line 3, the insulating layer 4, the second stretchable wiring line 5, and the chip components 20 and 30 of the stretchable substrate 2. With this configuration, the mounting board 10 (stretchable wiring board 1) can be easily attached to the living body. The entire mounting board 10 (stretchable wiring board 1) may be fixed to the living body by taping.

The whole of the mounting board 10 (stretchable wiring board 1) may be coated with a biocompatible resin material. With this configuration, the contact of the first stretchable wiring line 3, the second stretchable wiring line 5, and the chip components 20 and 30 with the living body is prevented.

The mounting board 10 (stretchable wiring board 1) may have a portion in which the skin of the living body is exposed to the outside air or is easily ventilated, in a region where the first stretchable wiring line 3, the second stretchable wiring line 5, and the chip components 20 and 30 are not arranged. With this configuration, in the mounting board 10 (stretchable wiring board 1), the ventilation with the skin of the living body is enhanced.

### DESCRIPTION OF REFERENCE SYMBOLS

- 1:: Stretchable wiring board
- 2:: Stretchable substrate
- 3:: First stretchable wiring line
- 4:: Insulating layer
- 5:: Second stretchable wiring line
- 10:: Mounting board
- 20, 30:: Chip component
- R1:: First region
- R2:: Second region
- R3:: Third region
- Z1:: Thickness of first stretchable wiring line
- Z2:: Thickness of insulating layer
- X, Z3:: Thickness of second stretchable wiring line
- C:: Corner of first stretchable wiring line
- Y:: Minimum length of second region

## Claims

1. A stretchable wiring board (1) comprising:
a stretchable substrate (2);
a first stretchable wiring line (3);
an insulating layer (4); and
a second stretchable wiring line (5),
wherein:
the first stretchable wiring line (3), the insulating layer (4), and the second stretchable wiring line (5) are arranged in a first region (R1) so as to sequentially overlap on a surface of the stretchable substrate (2);
the insulating layer (4) and the second stretchable wiring line (5) are arranged in a second region (R2) adjacent to the first region (R1) so as to sequentially overlap on the surface of the stretchable substrate (2);
the second stretchable wiring line (5) is arranged on the surface of the stretchable substrate (2) in a third region (R3) adjacent to the second region (R2);
the first stretchable wiring line (3) extends over the first region (R1) but not over the second region (R2) nor over the third region (R3);
the insulating layer (4) extends over the first region (R1) and the second region (R2) but not over the third region (R3);
the second stretchable wiring line (5) extends over the first region (R1), the second region (R2), and the third region (R3); and
when a thickness of the first stretchable wiring line (3) is defined as Z1, a thickness of the insulating layer (4) is defined as Z2, and a thickness of the second stretchable wiring line (5) is defined as Z3 at a position in the first region (R1) where a total thickness of the first stretchable wiring line (3), the insulating layer (4), and the second stretchable wiring line (5) becomes maximum, and when the thickness of the second stretchable wiring line (5) at a boundary between the second region (R2) and the third region (R3) is defined as X,
the stretchable wiring board (1) satisfies a relationship that X is smaller than Z1 + Z2 + Z3,
**characterized in that**
the stretchable wiring board (1) satisfies a relationship that X is larger than a larger of Z1 + Z2 and Z2 + Z3**.**

2. The stretchable wiring board (1) according to claim 1, wherein, when a minimum value of a length of the second region (R2) in the extending direction of the second stretchable wiring line (5) in plan view is defined as Y, the stretchable wiring board (1) satisfies a relationship of Y > Z2**.**

3. The stretchable wiring board (1) according to any one of claims 1 or 2, wherein the first stretchable wiring line (3) and the second stretchable wiring line (5) intersect with each other in plan view.

## Patentansprüche

1. Dehnbare Verdrahtungsplatte (1), umfassend:
ein dehnbares Substrat (2);
eine erste dehnbare Verdrahtungsleitung (3);
eine Isolierschicht (4); und
eine zweite dehnbare Verdrahtungsleitung (5),
wobei:
die erste dehnbare Verdrahtungsleitung (3), die Isolierschicht (4) und die zweite dehnbare Verdrahtungsleitung (5) in einem ersten Bereich (R1) so angeordnet sind, dass sie sich nacheinander auf einer Oberfläche des dehnbaren Substrats (2) überlappen;
die Isolierschicht (4) und die zweite dehnbare Verdrahtungsleitung (5) in einem zweiten Bereich (R2) benachbart zum ersten Bereich (R1) so angeordnet sind, dass sie sich auf der Oberfläche des dehnbaren Substrats (2) nacheinander überlappen;
die zweite dehnbare Verdrahtungsleitung (5) auf der Oberfläche des dehnbaren Substrats (2) in einem dritten Bereich (R3) benachbart zum zweiten Bereich (R2) angeordnet ist;
die erste dehnbare Verdrahtungsleitung (3) sich über den ersten Bereich (R1), jedoch weder über den zweiten Bereich (R2) noch über den dritten Bereich (R3) erstreckt;
die Isolierschicht (4) sich über den ersten Bereich (R1) und den zweiten Bereich (R2), jedoch nicht über den dritten Bereich (R3) erstreckt;
die zweite dehnbare Verdrahtungsleitung (5) sich über den ersten Bereich (R1), den zweiten Bereich (R2) und den dritten Bereich (R3) erstreckt; und
wenn eine Dicke der ersten dehnbaren Verdrahtungsleitung (3) als Z1 definiert ist, eine Dicke der Isolierschicht (4) als Z2 definiert ist und eine Dicke der zweiten dehnbaren Verdrahtungsleitung (5) als Z3 an einer Position in dem ersten Bereich (R1) definiert ist, wo eine Gesamtdicke der ersten dehnbaren Verdrahtungsleitung (3) der Isolierschicht (4) und der zweiten dehnbaren Verdrahtungsleitung (5) am größten wird, und wenn die Dicke der zweiten dehnbaren Verdrahtungsleitung (5) an einer Grenze zwischen dem zweiten Bereich (R2) und dem dritten Bereich (R3) als X definiert ist,
die dehnbare Verdrahtungsplatte (1) die Bedingung erfüllt, dass X kleiner als Z1 + Z2 + Z3 ist,
**dadurch gekennzeichnet, dass**
die dehnbare Verdrahtungsplatte (1) die Bedingung erfüllt, dass X größer als das größere von Z1 + Z2 und Z2 + Z3 ist.

2. Dehnbare Verdrahtungsplatte (1) nach Anspruch 1, wobei, wenn ein Mindestwert einer Länge des zweiten Bereichs (R2) in der Erstreckungsrichtung der zweiten dehnbaren Verdrahtungsleitung (5) in Draufsicht als Y definiert ist, die dehnbare Verdrahtungsplatte (1) eine Bedingung erfüllt von Y > Z2.

3. Dehnbare Verdrahtungsplatte (1) nach einem der Ansprüche 1 oder 2, wobei sich die erste dehnbare Verdrahtungsleitung (3) und die zweite dehnbare Verdrahtungsleitung (5) in der Draufsicht schneiden.

## Revendications

1. Carte de câblage étirable (1) comprenant :
un substrat étirable (2) ;
une première ligne de câblage étirable (3) ;
une couche isolante (4) ; et
une deuxième ligne de câblage étirable (5),
dans laquelle :
la première ligne de câblage extensible (3), la couche isolante (4) et la deuxième ligne de câblage extensible (5) sont disposées dans une première région (R1) de manière à se chevaucher séquentiellement sur une surface du substrat extensible (2) ;
la couche isolante (4) et la deuxième ligne de câblage étirable (5) sont disposées dans une deuxième région (R2) adjacente à la première région (R1) de manière à se chevaucher séquentiellement sur la surface du substrat étirable (2) ;
la deuxième ligne de câblage étirable (5) est disposée sur la surface du substrat étirable (2) dans une troisième région (R3) adjacente à la deuxième région (R2) ;
la première ligne de câblage étirable (3) s'étend sur la première région (R1) mais pas sur la deuxième région (R2) ni sur la troisième région (R3) ;
la couche isolante (4) s'étend sur la première région (R1) et la deuxième région (R2) mais pas sur la troisième région (R3) ;
la deuxième ligne de câblage étirable (5) s'étend sur la première région (R1), la deuxième région (R2) et la troisième région (R3) ; et
lorsqu'une épaisseur de la première ligne de câblage extensible (3) est définie comme Z1, une épaisseur de la couche isolante (4) est définie comme Z2, et une épaisseur de la deuxième ligne de câblage extensible (5) est définie comme Z3 sur une position dans la première région(R1) où une épaisseur totale de la première ligne de câblage extensible (3), de la couche isolante (4), et de la deuxième ligne de câblage extensible (5) devient maximale, et lorsque l'épaisseur de la deuxième ligne de câblage extensible (5) sur une limite entre la deuxième région (R2) et la troisième région (R3) est définie comme X,
la carte de câblage extensible (1) satisfait une relation selon laquelle X est plus petit que Z1 + Z2 + Z3,
**caractérisée en ce que**
la carte de câblage extensible (1) satisfait une relation selon laquelle X est plus grand que Z1 + Z2 et Z2 + Z3.

2. Carte de câblage extensible (1) selon la revendication 1, dans laquelle, lorsqu'une valeur minimale d'une longueur de la deuxième région (R2) dans la direction d'extension de la deuxième ligne de câblage extensible (5) dans une vue en plan est définie comme Y, la carte de câblage extensible (1) satisfait une relation Y > Z2.

3. Carte de câblage extensible (1) selon l'une quelconque des revendications 1 ou 2, dans laquelle la première ligne de câblage extensible (3) et la deuxième ligne de câblage extensible (5) se croisent l'une l'autre dans une vue en plan.
